(19) Europäisches Patentamt
European Patent Office
Office européen des brevets

(11) EP 4 564 066 A1

(12) **EUROPEAN PATENT APPLICATION**
published in accordance with Art. 153(4) EPC

(43) Date of publication:
**04.06.2025 Bulletin 2025/23**

(21) Application number: **23873026.1**

(22) Date of filing: **25.09.2023**

(51) International Patent Classification (IPC):
***G02B 5/20*** (2006.01) ***G02B 5/18*** (2006.01)
***C08K 7/04*** (2006.01) ***H10K 50/85*** (2023.01)
***C08K 3/22*** (2006.01) ***C08K 3/36*** (2006.01)
***C08L 27/18*** (2006.01) ***C08L 79/08*** (2006.01)
***C08G 73/10*** (2006.01) ***C08J 7/043*** (2020.01)

(52) Cooperative Patent Classification (CPC):
**C08G 73/10; C08J 7/043; C08K 3/22; C08K 3/36; C08K 7/04; C08L 27/18; C08L 79/08; G02B 5/18; G02B 5/20; H10K 50/85**

(86) International application number:
**PCT/KR2023/014665**

(87) International publication number:
**WO 2024/071909 (04.04.2024 Gazette 2024/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.09.2022 KR 20220123417**
**21.09.2023 KR 20230126644**

(71) Applicant: **Kolon Industries, Inc.**
**Seoul 07793 (KR)**

(72) Inventors:
- **CHOI, Min-Hee**
**Seoul 07793 (KR)**
- **PARK, Hyo Jun**
**Seoul 07793 (KR)**

(74) Representative: **Ter Meer Steinmeister & Partner Patentanwälte mbB**
**Nymphenburger Straße 4**
**80335 München (DE)**

(54) **OPTICAL FILM AND DISPLAY DEVICE COMPRISING SAME**

(57) Provides are optical film and a display device comprising same, the optical film according to an embodiment of the present invention comprising light-transmissive base material, and a filler dispersed therein, the filler being in the form of fiber, and the optical film having dynamic toughness deformation index of 10.5% or less.

FIG. 1

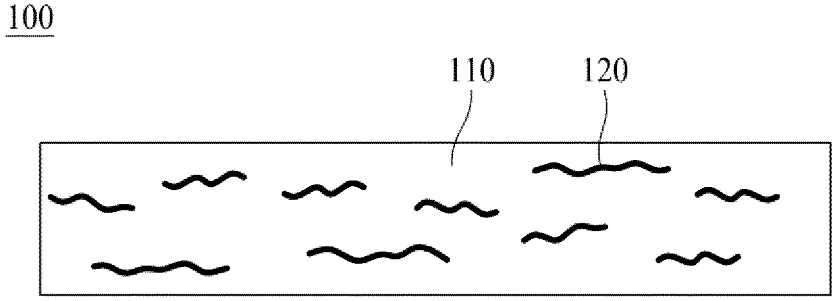


EP 4 564 066 A1

## Description

[Technical Field]

The present disclosure relates to an optical film and a display device including the same and more particularly, to an optical film having a low driving toughness change index and excellent weather resistance.

[Background Art]

Recently, the use of an optical film instead of glass as a cover window of a display device has been considered with the goal of reducing thickness and weight and increasing the flexibility of the display device. In order for the optical film to be usable as a cover window of a display device, the optical film needs to have superior optical properties and excellent mechanical properties. For example, an optical film needs to have properties such as excellent strength, hardness, abrasion resistance, and flexibility.

Fillers may be added in order to impart desired physical properties to an optical film requiring various physical properties. The fillers may vary depending on physical properties required for the optical film.

[Disclosure]

[Technical Problem]

Therefore, the present disclosure has been made in view of the above problems, and it is one aspect of the present disclosure to provide an optical film that includes a fiber-shape filler dispersed in a light-transmitting matrix.

It is another aspect of the present disclosure to provide an optical film that includes a fiber-shape filler dispersed in a light-transmitting matrix and thereby exhibits excellent driving toughness.

It is another aspect of the present disclosure to provide an optical film that includes a fiber-shape filler dispersed in a light-transmitting matrix and thereby exhibits excellent driving toughness change index.

It is another aspect of the present disclosure to provide an optical film that includes a fiber-shape filler dispersed in a light-transmitting matrix and thereby exhibits excellent driving elastic limit.

It is another aspect of the present disclosure to provide a cover window substrate including the optical film.

It is another aspect of the present disclosure to provide a display device including the optical film.

[Technical Solution]

In accordance with one aspect of the present disclosure, provided is an optical film including a light-transmitting matrix and a filler dispersed in the light-transmitting matrix,

wherein the filler has a fiber shape and a driving toughness change index of 10.5% or less, wherein the driving toughness change index is calculated in accordance with Equation 1 below:

[Equation 1]

$$\text{Driving toughness change index}(\%) = \frac{\text{First driving toughness} - \text{Second driving toughness}}{\text{First driving toughness}} \times 100$$

wherein the first driving toughness is driving toughness measured after treatment under room temperature and humidity conditions,
the treatment under room temperature and humidity conditions is performed by allowing the optical film to stand at a temperature of 25°C ± 3°C and humidity of 30% ± 5% for 1 hour,
the second driving toughness is driving toughness measured after treatment under high temperature and humidity conditions,
the treatment under high temperature and humidity conditions is performed by allowing the optical film to stand at a temperature of 60°C ± 3°C and humidity of 90% ± 5% for 1 hour, and
the driving toughness is defined by measuring a ratio of strain to stress of the optical film using a dynamic mechanical analyzer (DMA), obtaining a strain-stress curve using the strain of the optical film on an x-axis and the stress of the optical film on a y-axis, and calculating a product of an area at a strain of 1.6% or less in the strain-stress curve, by a length of a specimen.

The optical film may have a first driving toughness of 240 MPa·mm or more.

The optical film may have a second driving toughness of 217 MPa·mm or more.

The optical film may have a first driving elastic limit of 155 MPa·mm or more, wherein the first driving elastic limit is calculated in accordance with Equation 2 below:

First driving elastic limit = first driving toughness / first driving strain rate [Equation 2]

wherein the first driving strain rate is 1.6%.

The optical film may have a second driving elastic limit of 140 MPa·mm or more, wherein the second driving elastic limit is calculated in accordance with Equation 3 below:

Second driving elastic limit = second driving toughness / second driving strain rate [Equation 3]

wherein the second driving strain rate is 1.6%.

The filler may include at least one of glass fiber, aluminum-based fiber, or fluoride fiber.

The filler may include at least one of aluminum oxide hydroxide, $SiO_2$, $Al_2O_3$, polytetrafluoroethylene (PTFE), or polyvinylidene fluoride (PVDF).

The light-transmitting matrix may be produced from a polymerizable composition, and may contain a diamine monomer, and at least one of a dianhydride compound or a dicarbonyl compound.

The light-transmitting matrix may include at least one of an imide repeating unit or an amide repeating unit.

The diamine monomer may include at least one of 2,2'-bis(trifluoromethyl)benzidine (TFDB), 4,4'-oxydianiline (ODA), p-phenylene diamine (pPDA), m-phenylene diamine (mPDA), p-methylene diamine (pMDA), m-methylene diamine (mMDA), 1,3-bis(3-aminophenoxy)benzene (133APB), 1,3-bis(4-aminophenoxy)benzene (134APB), 2,2'-bis [4(4-aminophenoxy)phenyl]hexafluoropropane (4BDAF), 2,2'-bis(3-aminophenyl)hexafluoropropane (33-6F), 2,2'-bis(4-aminophenyl)hexafluoropropane (44-6F), bis(4-aminophenyl)sulfone (4DDS), bis(aminophenyl)sulfone (3DDS), 1,3-cyclohexanediamine (13CHD), 1,4-cyclohexanediamine (14CHD), 2,2-bis[4-(4-aminophenoxy)-phenyl]propane (6HMDA), 2,2-bis(3-amino-4-hydroxy-phenyl)-hexafluoropropane (DBOH), or 4,4'-bis(3-aminophenoxy)diphenyl sulfone (DBSDA).

The dianhydride compound may include at least one of 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), 1,2,4,5-benzene tetracarboxylic dianhydride (pyromellitic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), 4,4-bis(3,4-dicarboxyphenoxy)diphenyl sulfide dianhydride (BDSDA), sulfonyl diphthalic anhydride (SO2DPA), cyclobutane-1,2,3,4-tetracarboxylic dianhydride (CBDA), or 4,4'-(4,4'-isopropylidenediphenoxy)bis(phthalic anhydride) (6HBDA).

The dicarbonyl compound may include at least one of terephthaloyl chloride (TPC), phthaloyl chloride, isophthaloyl chloride (IPC), 4,4'-biphenyldicarbonyl chloride (DPDOC), 4,4'-oxybis (benzoyl chloride) (OBBOC), naphthalene-2,3-dicarbonyl dichloride, or 1,4-cyclohexanedicabonyldichloride (CHDOC).

A molar ratio of the dianhydride compound to the dicarbonyl compound may fall within a range of 5:95 to 40:60.

In accordance with another aspect of the present disclosure, provided is a cover window substrate including the optical film.

In accordance with another aspect of the present disclosure, provided is a cover window substrate including a light-transmitting sheet and a coating layer disposed on the light-transmitting sheet, wherein the light-transmitting sheet includes the optical film.

The cover window substrate may further include a primer layer between the light-transmitting sheet and the coating layer.

In accordance with another aspect of the present disclosure, provided is a display device including a display panel and the optical film disposed on the display panel.

[Advantageous Effects]

According to one embodiment of the present disclosure, the filler included in the optical film has a fiber shape and can engage polymer chains constituting the light-transmitting matrix. As a result, the optical film can exhibit superior mechanical strength, particularly, excellent driving toughness and driving toughness change index.

In addition, according to an embodiment of the present disclosure, the optical film can exhibit excellent driving elastic limit and driving elastic limit index.

According to an embodiment of the present disclosure, the optical film containing a fiber filler may exhibit excellent mechanical properties in addition to excellent optical properties. The optical film according to an embodiment of

the present disclosure may exhibit excellent optical and mechanical properties, thus being useful as a cover window of a display device.

[Description of Drawings]

FIG. 1 is a schematic diagram illustrating an optical film according to an embodiment of the present disclosure.

FIG. 2 is a schematic diagram illustrating a cover window substrate according to another embodiment of the present disclosure.

FIG. 3 is a schematic diagram illustrating a cover window substrate according to yet another embodiment of the present disclosure.

FIG. 4 is a cross-sectional view illustrating a part of a display device according to another embodiment of the present disclosure.

FIG. 5 is an enlarged cross-sectional view illustrating part "P" in FIG. 4.

FIG. 6 is a cross-sectional view illustrating an exterior appearance of a display device according to another embodiment of the present disclosure.

FIG. 7 is a strain-stress curve after treatment under room temperature and humidity conditions in Examples 1 and 2 and Comparative Example 1.

FIG. 8 is a strain-stress curve after treatment under high temperature and high humidity conditions in Examples 1 and 2 and Comparative Example 1.

FIG. 9 is a strain-stress curve after treatment under room temperature and humidity conditions in Examples 3 and 4 and Comparative Example 2.

FIG. 10 is a strain-stress curve after treatment under high temperature and high humidity conditions in Examples 3 and 4 and Comparative Example 2.

FIG. 11 is a strain-stress curve after treatment under room temperature and humidity conditions in Examples 5 and 6 and Comparative Example 3.

FIG. 12 is a strain-stress curve after treatment under high temperature and high humidity conditions in Examples 5 and 6 and Comparative Example 3.

[Best Mode]

Hereinafter, embodiments of the present disclosure will be described in detail with reference to the accompanying drawings. However, the following embodiments are illustratively provided merely for clear understanding of the present disclosure and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which a term such as "comprise", "have", or "include" is used in the present specification, another part may also be present, unless "only" is also used. Terms in a singular form may include the plural meanings, unless noted to the contrary. Also, in construing an element, the element is to be construed as including an error range, even if there is no explicit description thereof.

In describing a positional relationship, for example, when the positional relationship is described using "on", "above", "below", or "next to", the case of no contact therebetween may be included, unless "immediately" or "directly" is used.

Spatially relative terms, such as "below", "beneath", "lower", "above", and "upper", may be used herein to describe the relationship between a device or element and another device or element, as shown in the FIG.s. It will be understood that spatially relative terms are intended to encompass different orientations of a device during the use or operation of the device, in addition to the orientation depicted in the FIG.s. For example, if a device in one of the FIG.s is turned upside down, elements described as "below" or "beneath" other elements would then be positioned "above" the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when a temporal order is described using "after", "subsequent", "next", or "before", the case of a non-continuous relationship may be included, unless "immediately" or "directly" is used.

It will be understood that, although the terms "first", "second", etc. may be used herein to describe various elements, these elements are not limited by these terms. These terms are only used to distinguish one element from another. Therefore, a first element could be termed a second element within the technical idea of the present disclosure.

It should be understood that the term "at least one" includes all combinations related with one or more items. For example, "at least one among a first element, a second element, and a third element" may include all combinations of two or more elements selected from among the first, second, and third elements, as well as each of the first, second, and third elements.

Features of various embodiments of the present disclosure may be partially or completely integrated or combined with each other, and may be variously interoperated with each other and driven technically. The embodiments of the present disclosure may be carried out independently from each other, or may be carried out together in an interrelated manner.

FIG. 1 is a schematic diagram illustrating an optical film 100 according to an embodiment of the present disclosure. According to one embodiment of the present disclosure, a film having light transmittance is referred to as an "optical film 100".

The optical film 100 according to an embodiment of the present disclosure includes a light-transmitting matrix 110 and a filler 120 dispersed in the light-transmitting matrix 110.

The light-transmitting matrix 110 according to an embodiment of the present disclosure may be light-transmissive. According to an embodiment of the present disclosure, the light-transmitting matrix 110 may be flexible. For example, the optical film according to an embodiment of the present disclosure may be bendable, foldable, or rollable. As a result, the optical film 100 according to an embodiment of the present disclosure may be light-transmissive and may be bendable, foldable, or rollable.

Physical properties that are used to confirm the reliability of flexible materials include mechanical properties such as strength, hardness, strain, and elastic modulus. The mechanical property of a material refers to the degree the material responds to an external stimulus, for example, the collation between external force and the deformation of the material caused thereby. To determine the deformation of a material, to which external force is applied, for example, the stress relaxation behavior may be evaluated using a universal tensile tester (UTM) or a dynamic mechanical analyzer (DMA).

According to an embodiment of the present disclosure, the light-transmitting matrix 110 may include at least one of an imide repeating unit or an amide repeating unit.

The light-transmitting matrix 110 according to an embodiment of the present disclosure may be prepared from monomeric ingredients including dianhydrides and diamines. Specifically, the light-transmitting matrix 110 may include an imide repeating unit formed by dianhydride and diamine.

However, the light-transmitting matrix 110 according to an embodiment of the present disclosure is not limited thereto, and the light-transmitting matrix 110 may be produced from monomeric ingredients including a dicarbonyl compound in addition to dianhydride and diamine. The light-transmitting matrix 110 according to an embodiment of the present disclosure may have an imide repeating unit and an amide repeating unit. For example, the light-transmitting matrix 110 having an imide repeating unit and an amide repeating unit may be a polyamide-imide resin.

According to one embodiment of the present disclosure, the light-transmitting matrix 110 may include a polyimide-based polymer. Examples of the polyimide-based polymer may include polyimide polymers, polyamide polymers, polyamide-imide polymers and the like. The light-transmitting matrix 110 according to an embodiment of the present disclosure may be formed of, for example, a polyamide-imide-based polymer resin.

According to one embodiment, the light-transmitting matrix 110 may be prepared from a polymerizable composition.

The polymerizable composition according to an embodiment of the present disclosure may contain a diamine-based monomer.

According to one embodiment of the present disclosure, the diamine monomer, for example, may include at least one of 2,2'-bis(trifluoromethyl)benzidine (TFDB), 4,4'-oxydianiline (ODA), p-phenylene diamine (pPDA), m-phenylene diamine (mPDA), p-methylene diamine (pMDA), m-methylene diamine (mMDA), 1,3-bis(3-aminophenoxy) benzene

(133APB), 1,3-bis(4-aminophenoxy) benzene (134APB), 2,2'-bis[4(4-aminophenoxy)phenyl]hexafluoropropane (4BDAF), 2,2'-bis(3-aminophenyl)hexafluoropropane (33-6F), 2,2'-bis(4-aminophenyl)hexafluoropropane (44-6F), bis(4-aminophenyl)sulfone (4DDS), bis(aminophenyl) sulfone (3DDS), 1,3-cyclohexanediamine (13CHD), 1,4-cyclohexanediamine (14CHD), 2,2-bis[4-(4-aminophenoxy)-phenyl]propane (6HMDA), 2,2-bis(3-amino-4-hydroxy-phenyl)-hexafluoropropane (DBOH), and 4,4'-bis(3-aminophenoxy)diphenyl sulfone (DBSDA), but is not limited thereto.

The polymerizable composition according to an embodiment of the present disclosure may contain at least one of a dianhydride compound or a dicarbonyl compound.

According to one embodiment of the present disclosure, the dianhydride compound may, for example, include at least one of 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), 1,2,4,5-benzene tetracarboxylic dianhydride (pyromellitic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), 4,4-bis(3,4-dicarboxyphenoxy)diphenyl sulfide dianhydride (BDSDA), sulfonyl diphthalic anhydride (SO2DPA), cyclobutane-1,2,3,4-tetracarboxylic dianhydride (CBDA), or 4,4'-(4,4'-isopropylidenediphenoxy)bis(phthalic anhydride) (6HBDA), but is not limited thereto.

According to one embodiment of the present disclosure, the dicarbonyl compound may, for example, include at least one of terephthaloyl chloride (TPC), phthaloyl chloride, isophthaloyl chloride (IPC), 4,4'-biphenyldicarbonyl chloride (DPDOC), 4,4'-oxybis(benzoyl chloride) (OBBOC), naphthalene-2,3-dicarbonyl dichloride, or 1,4-cyclohexanedicabonyldichloride (CHDOC), but is not limited thereto.

According to one embodiment of the present disclosure, the total equivalent weight of the dianhydride compound and the dicarbonyl compound may be substantially the same as the equivalent weight of the diamine monomer.

The polymerizable composition according to an embodiment of the present disclosure may contain 60 mol% or more of the dicarbonyl compound with respect to the total number of moles of the dianhydride compound and the dicarbonyl compound to ensure excellent mechanical properties.

For example, the molar ratio of the dianhydride compound to the dicarbonyl compound may be within the range of 5:95 to 40:60.

According to one embodiment of the present disclosure, the filler 120 may have a fiber shape. For example, the fiber may, for example, refer to a material whose length is much greater than the diameter thereof. The fiber may refer to a thin, long, thread-like material. The fiber may refer to a material with a linear structure. The fiber may also refer to a long and bendable material.

Hereinafter, a shape having a length greater than a diameter is referred to as a "fiber shape". The fiber shape may also be referred to as a "filament shape". According to one embodiment of the present disclosure, the length of the filler 120 may be more than twice the diameter thereof.

According to one embodiment of the present disclosure, the filler 120 has a fiber shape and thus can engage (or link, or connect, or entangle) the polymer chains constituting the light-transmitting matrix 110. As a result, the stability and arrangement characteristics of the polymer chains can be improved, the mechanical properties of the light-transmitting matrix 110 can be improved, and the mechanical properties of the optical film 100 can also be improved.

There is no particular limitation on the type of filler 120. Any filler may be used without limitation as the filler 120 according to an embodiment of the present disclosure so long as it has a fiber shape. The filler 120 may be inorganic or organic. The filler 120 may include at least one of inorganic fibers, organic fibers, or organic-inorganic hybrid fibers.

More specifically, the filler 120 may have a fiber shape. For example, the filler 120 may have a single-stranded fiber shape, a multi-stranded fiber shape, or a branch shape in which multiple strands are arranged in the form of branches based on one central strand.

According to one embodiment of the present disclosure, the filler 120 may include at least one of a glass fiber, an aluminum-based fiber, or a fluoride fiber.

The glass fiber may contain $SiO_2$ and may further contain other components in addition to $SiO_2$. The aluminum-based fiber may contain aluminum oxide hydroxide or $Al_2O_3$. The aluminum-based fiber may further contain other components in addition to aluminum oxide hydroxide or $Al_2O_3$. The fluoride fiber may contain at least one of polytetrafluoroethylene (PTFE) or polyvinylidene fluoride (PVDF), and may further contain other components in addition to PTFE and PVDF.

According to one embodiment of the present disclosure, the filler 120 may include at least one of aluminum oxide hydroxide, $SiO_2$, $Al_2O_3$, polytetrafluoroethylene (PTFE), or polyvinylidene fluoride (PVDF).

According to one embodiment of the present disclosure, the filler 120 may be surface-treated. For example, the filler 120 may be fiber surface-treated with an organic compound having an alkoxy group.

According to one embodiment of the present disclosure, the aluminum-based fiber may include at least one of aluminum oxide hydroxide or $Al_2O_3$. Aluminum oxide hydroxide is also called "Boehmite" and can be represented by $\gamma$-AlO(OH). More specifically, aluminum oxide hydroxide may include a structure represented by any of the following formulas 1, 2, and 3.

[Formula 1]

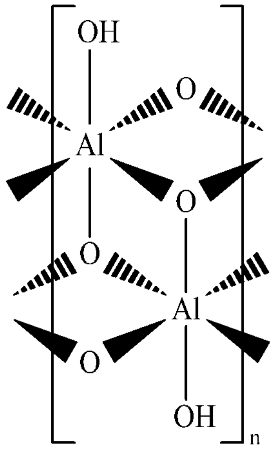

[Formula 2]

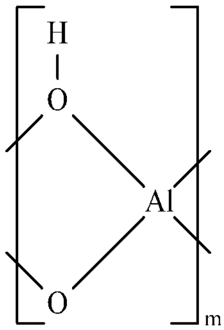

[Formula 3]

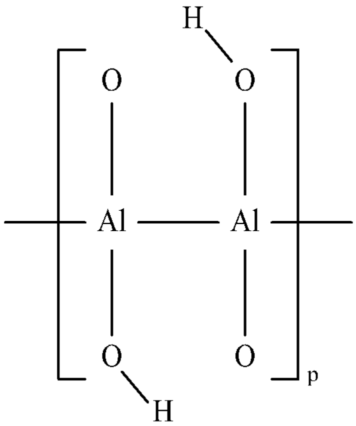

wherein n ranges from 50 to 10,000, m ranges from 50 to 10,000, and p ranges from 100 to 20,000.

When the structures of Formulas 1, 2 and 3 are expanded for better understanding of the structure of the filler 120, the filler 120 may be represented by any one of Formulas 4, 5 and 6.

The structure represented by Formula 1 may be represented by, for example, Formula 4 below. Formula 4 below corresponds to the structure of Formula 1 wherein n is 5.

[Formula 4]

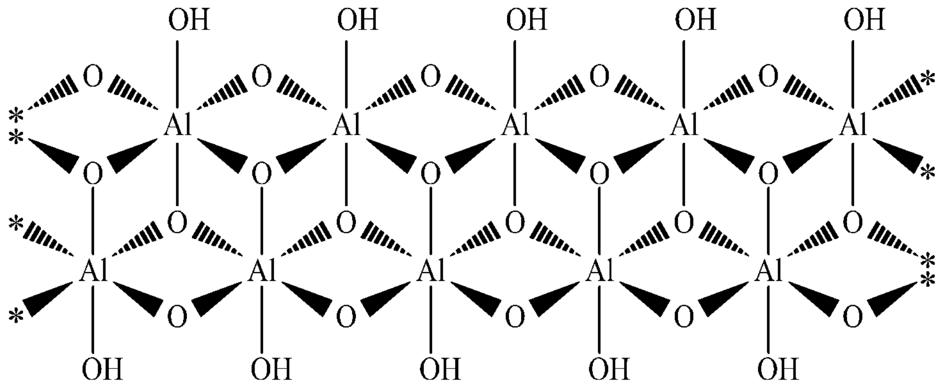

The structure represented by Formula 2 may be represented by, for example, Formula 5 below. Formula 5 below corresponds to the structure of Formula 2 wherein m is 4.

[Formula 5]

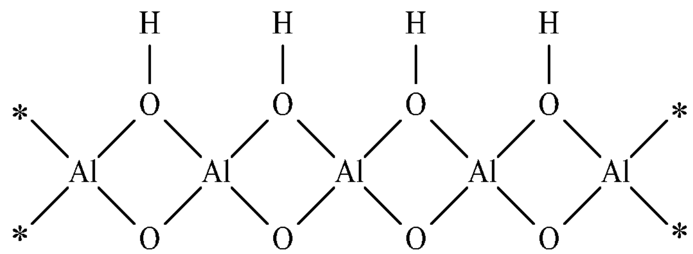

The structure represented by Formula 3 may be represented by, for example, Formula 6 below. Formula 6 below corresponds to the structure of Formula 3 wherein p is 3.

[Formula 6]

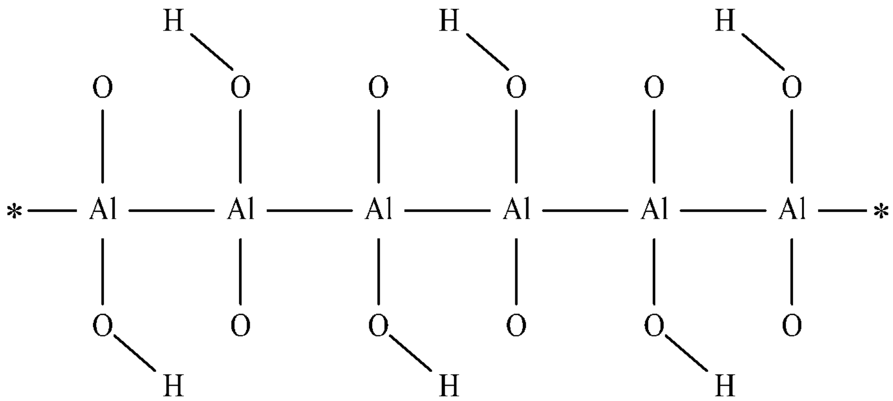

In Formulas 4 to 6, "*" represents a binding position.

According to an embodiment of the present disclosure, $Al_2O_3$ may have a unit structure represented by Formula 7 below.

[Formula 7]

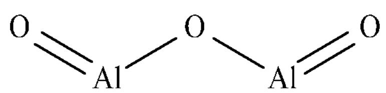

According to an embodiment of the present disclosure, $SiO_2$ may have a unit structure represented by Formula 8

below.

[Formula 8]

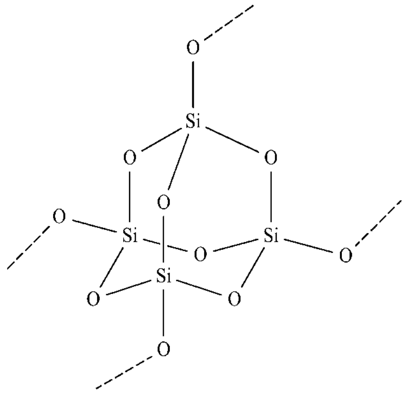

According to one embodiment of the present disclosure, the filler 120 may have a diameter of 2 to 10 nm and a length of 200 nm to 4,000 nm.

According to one embodiment of the present disclosure, the diameter and length of the filler 120 may be measured with a transmission electron microscope (TEM).

When the diameter of the filler 120 is less than 2 nm, the stability of the filler 120 may decrease and the filler may be cut or broken, thus contaminating the optical film 100 and increasing the haze of the optical film 100. When the diameter of the filler 120 is higher than 10 nm, the filler 120 has difficulty in having a fiber shape and the optical film 100 may have deteriorated function of engaging polymer chains and decreased light transmittance.

When the length of the filler 120 is less than 200 nm, the function of the filler 120 to engage polymer chains may not be sufficiently exerted. When the length of the filler 120 is higher than 4,000 nm, the dispersibility of the filler 120 may decrease, and as a result, agglomeration of the filler 120 may occur within the light-transmitting matrix 110. Accordingly, the light transmittance of the optical film 100 may decrease and haze thereof may increase, and the optical properties of the optical film 100 may deteriorate.

According to one embodiment of the present disclosure, the length of the filler 120 may be adjusted by growth or post-treatment conditions of the filler 120. For example, the length of the filler 120 can be appropriately adjusted by controlling the temperature when growing the filler 120. In addition, ultrasonic waves or other energy may be applied to the filler 120 grown to a predetermined length so that the filler 120 is cut to a predetermined length.

According to an embodiment of the present disclosure, the filler 120 may cause appropriate light scattering to improve the optical properties of the optical film 100.

According to an embodiment of the present disclosure, the filler 120 may improve tensile properties. As a result, greater force is required to elongate the optical film 100 by the same length. Accordingly, the mechanical properties of the optical film 100 can be improved.

However, when the content of the filler 120 is excessive, the yield point of the optical film 100 may be lowered and the elasticity of the optical film 100 may be insufficient. When the content of the filler 120 is small, the improvement in the mechanical properties of the optical film 100 may be insufficient.

Therefore, in order to obtain appropriate strength and elasticity of the optical film 100, the content of the filler 120 in the optical film 100 may be adjusted within an appropriate range.

For example, the filler 120 may be added in an amount of 2 to 20 wt% of the solid content of the polymerizable composition. Specifically, the filler 120 may be added in an amount of 3 to 15 wt% of the solid content of the polymerizable composition. More specifically, the filler 120 may be added in an amount of 3 to 10 wt% of the solid content of the polymerizable composition.

According to an embodiment of the present disclosure, the mechanical properties of the optical film 100 can be improved by adjusting the content of the filler 120 and improving the dispersion method. For example, the driving toughness and elastic limit of the optical film 100 may be improved. In addition, the optical film 100 may undergo almost no deterioration in mechanical properties even after treatment under high temperature and high humidity conditions. Accordingly, by adjusting the content of the filler 120 and improving the dispersion method, weather resistance and long-term stability as well as mechanical properties of the optical film 100 can be improved.

The optical film 100 according to an embodiment of the present disclosure may have excellent driving toughness.

Driving toughness refers to the product of an area of an elastic region in the strain-stress curve and a length (mm) of a specimen for the optical film 100. For example, high driving toughness means that a high force is required to deform a specimen until plastic deformation occurs due to a wide elastic zone. For example, the specimen for the optical film 100

may be produced to have a length (L) x width (W) x thickness (T) of 5 mm x 2 mm x 0.05 mm. The unit of driving toughness is MPa·mm.

In the strain-stress curve, a part where a stress increases at a constant rate as a strain increases and thus a slope is almost constant is defined as an "elastic region", and the deformation of a material within this region is defined as "elastic deformation". On the other hand, a part where the slope and curve shape rapidly change is defined as a "plastic region", and it is considered that plastic deformation starts as dislocation occurs in the internal structure of the material.

FIG. 6 is a cross-sectional view illustrating an exterior appearance of a display device according to another embodiment of the present disclosure. More specifically, FIG. 6 is a schematic side view illustrating a foldable display device in a folded state.

Referring to FIG. 6, a display device 600 according to another embodiment of the present disclosure may include an optical film 100 according to one embodiment of the present disclosure and a case 601. The display device 600 may be a bendable or foldable device, such as a foldable display device. In addition, R means the radius of curvature.

As shown in FIG. 6, when the display device 600 including the optical film 100 according to an embodiment of the present disclosure is folded, the optical film 100 may be bent by a radius of curvature (R) of 1.5 mm, based on a thickness of 50 $\mu$m. In addition, a space 701 may be formed by the bent optical film 100.

When the optical film 100 according to an embodiment of the present disclosure is bent by a radius of curvature (R) of 1.5 mm based on a thickness of 50 $\mu$m, the strain (%) of the outermost of the optical film 100 is 1.6%. Accordingly, the driving toughness of the optical film 100 can be obtained based on the strain of 1.6% of the outermost of the optical film 100.

More specifically, the driving toughness is obtained by measuring a ratio of strain to stress of the optical film 100 using a dynamic mechanical analyzer (DMA), obtaining a strain-stress curve using the strain of the optical film 100 on the x-axis and the stress of the optical film 100 on the y-axis, and calculating the product of an area with a strain of 1.6% or less in the strain-stress curve, by the length of the specimen.

According to another embodiment of the present disclosure, the optical film 100 may be disposed on the display device 600 and may be thus used under various environmental conditions for a long period of time. The optical film 100 may be deformed when it is repeatedly folded and unfolded under various environmental conditions. To prevent this deformation, it is necessary for the optical film to maintain elasticity under strain or stress conditions.

In order to evaluate the ability of the optical film 100 to maintain elasticity, the ability to maintain driving toughness may be evaluated after the optical film 100 is treated under harsh conditions, for example, high temperature and high humidity conditions.

According to one embodiment of the present disclosure, the optical film 100 may be manufactured such that the change in driving toughness is reduced after treatment under room temperature and humidity conditions and then treatment under high temperature and high humidity conditions.

The optical film 100 according to an embodiment of the present disclosure may have a first driving toughness of 240 MPa·mm or more.

The first driving toughness refers to driving toughness measured after treatment under room temperature and humidity conditions.

The treatment under room temperature and humidity conditions means that the optical film 100 is allowed to stand at a temperature of 25°C $\pm$ 3°C and humidity of 30% $\pm$ 5% for 1 hour.

When the first driving toughness is less than 240 MPa·mm, the optical film 100 may not be able to resist external force well under room temperature and humidity conditions and may be deformed. For example, when the optical film 100 is used as a cover window for a foldable device, it may be repeatedly folded and unfolded for a long period of time and deformation may occur in the folded part and visibility may be deteriorated. In addition, when the optical film 100 is pressed by external force, a mark is easily left even by a mild stimulus corresponding to a 1H pencil hardness level and may not be restored over time.

The optical film 100 according to an embodiment of the present disclosure may have a second driving toughness of 217 MPa·mm or more.

The second driving toughness refers to driving toughness measured after treatment under high temperature and high humidity conditions.

The treatment under high temperature and high humidity conditions means that the optical film is allowed to stand at a temperature of 60°C $\pm$ 3°C and a humidity of 90% $\pm$ 5% for 1 hour.

When the second driving toughness is less than 217 MPa·mm, the optical film 100 may not be able to resist external force well under high temperature and high humidity conditions and thus may be deformed. For example, when the optical film 100 is used as a cover window for a foldable device, it is repeatedly folded and unfolded in a state in which it is heated while high-definition videos are played and the folded area may be deformed and visibility may be reduced.

The optical film 100 according to an embodiment of the present disclosure may have a driving toughness change index of 10.5% or less.

The driving toughness change index refers to the change to the driving toughness (second driving toughness) of the optical film after treatment at high temperature and humidity from the driving toughness (first driving toughness) of the

optical film after treatment at room temperature and humidity. For example, a small driving toughness change index means that the optical film has excellent mechanical properties at high temperature and high humidity.

The driving toughness change index is calculated in accordance with Equation 1 below. The unit of driving toughness change index is %.

[Equation 1]

$$\text{Driving toughness change index}(\%) = \frac{\text{First driving toughness} - \text{Second driving toughness}}{\text{First driving toughness}} \times 100$$

When the driving toughness change index is higher than 10.5%, the stress greatly may decrease as temperature and humidity increase and thus the optical film may be inapplicable to a foldable device.

The optical film 100 according to an embodiment of the present disclosure may have a first driving elastic limit of 155 MPa·mm or more.

The term "driving elastic limit" refers to a ratio of a force required to deform a material to a strain and indicates force required to deform a material at 1%. For example, a film having a great driving elastic limit may exhibit excellent toughness and strength. The unit of the driving elastic limit is MPa·mm.

The first driving elastic limit is calculated in accordance with Equation 2 below.

First driving elastic limit = first driving toughness /first driving strain rate [Equation 2]

The first driving strain rate is 1.6%. The first driving strain rate is limited to 1.6% which corresponds to the strain of the outermost of the film when the radius of curvature (R) of a 50 μm thick film is 1.5 mm.

When the first driving elastic limit is less than 155 MPa·mm, the optical film 100 is easily deformed due to low resistance to external force.

The optical film 100 according to an embodiment of the present disclosure may have a second driving elastic limit of 140 MPa·mm or more.

The second driving elastic limit is calculated in accordance with Equation 3 below.

Second driving elastic limit = second driving toughness/second driving strain rate [Equation 3]

The second driving strain rate is 1.6%. The first driving strain rate is limited to 1.6% which corresponds to the strain of the outermost of the film when the radius of curvature (R) of a 50 μm thick film is 1.5 mm.

When the second driving elastic limit is less than 140 MPa·mm, the optical film 100 is easily deformed by external forces at high temperature and humidity.

The optical film 100 according to an embodiment of the present disclosure may have a modulus of 7.5 GPa or more.

The modulus of the optical film 100 according to an embodiment of the present disclosure may be measured on an optical film sample with a size of 10 mm x 100 mm using a universal tensile tester in accordance with ASTM D885. For example, the universal tensile tester may be MODEL 5967 from Instron Corp.

In general, it is known that it is difficult for a film formed of a polymer resin to achieve a modulus of 6.0 GPa or more. However, according to one embodiment of the present disclosure, the filler 120 has a fiber shape and can engage polymer chains constituting the light-transmitting matrix 110. As a result, the stability and arrangement characteristics of polymer chains are improved and intermolecular attraction is increased, so that the optical film 100 has a high modulus of 7.5 GPa or more.

More specifically, the optical film 100 according to an embodiment of the present disclosure may have a modulus of 8.0 GPa or more, and may have a modulus of 9.0 GPa or more.

The light-transmitting matrix 110 according to an embodiment of the present disclosure may have a thickness sufficient to protect the display panel. For example, the light-transmitting matrix 110 may have a thickness of 10 to 100 μm. The thickness of the light-transmitting matrix 110 may be the same as the thickness of the optical film 100.

FIG. 2 is a schematic diagram illustrating a cover window substrate 200 according to another embodiment of the present disclosure.

The cover window substrate 200 according to another embodiment of the present disclosure may include an optical film 100 according to an embodiment of the present disclosure.

The cover window substrate 200 according to another embodiment of the present disclosure may further include a coating layer 130 on a light-transmitting sheet in order to improve the surface properties of the light transmissive matrix

and the cover window substrate 200. The light-transmitting matrix may include an optical film 100 according to an embodiment of the present disclosure.

FIG. 3 is a schematic diagram illustrating a cover window substrate 300 according to another embodiment of the present disclosure.

The cover window substrate 300 according to another embodiment of the present disclosure further includes a primer layer 140 between the light-transmitting sheet and the coating layer 130 in order to improve adhesion between the light-transmitting sheet and the coating layer 130.

Hereinafter, a display device 400 using the optical film 100 according to an embodiment of the present disclosure will be described with reference to FIGS. 4 and 5.

FIG. 4 is a cross-sectional view illustrating a part of a display device 400 according to another embodiment of the present disclosure and FIG. 5 is an enlarged cross-sectional view of "P" in FIG. 4.

Referring to FIG. 4, the display device 400 according to another embodiment of the present disclosure includes a display panel 501 and an optical film 100 on the display panel 501.

Referring to FIGs. 4 and 5, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 400 shown in FIGs. 4 and 5 is an organic light-emitting display device.

The substrate 510 may be formed of glass or plastic. Specifically, the substrate 510 may be formed of plastic such as a polyimide-based resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and at least partially overlaps the semiconductor layer 520, a source electrode 541 connected to the semiconductor layer 520, and a drain electrode 542 that is spaced apart from the source electrode 541 and is connected to the semiconductor layer 520.

Referring to FIG. 5, a gate insulating layer 535 is disposed between the gate electrode 530 and the semiconductor layer 520. An interlayer insulating layer 551 may be disposed on the gate electrode 530, and a source electrode 541 and a drain electrode 542 may be disposed on the interlayer insulating layer 551.

A planarization layer 552 is disposed on the thin film transistor TFT to planarize the top of the thin film transistor TFT.

A first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer, or two or more light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed on the light path.

A thin-film encapsulation layer 590 may be disposed on the second electrode 573. The thin-film encapsulation layer 590 may include at least one organic layer and at least one inorganic layer, and the at least one organic layer and the at least one inorganic layer may be alternately disposed.

The optical film 100 according to an embodiment of the present disclosure may be disposed on the display panel 501 having the stack structure described above. The optical film 100 may include a light-transmitting matrix 110 and a filler 120 dispersed in the light-transmitting matrix 110.

In addition, cover window substrates 200 and 300 may be disposed on the display panel 501 having the laminated structure described above. The cover window substrates 200 and 300 may include an optical film 100 according to an embodiment of the present disclosure.

Hereinafter, a method of manufacturing an optical film 100 according to another embodiment of the present disclosure will be described.

The method of manufacturing an optical film 100 according to an embodiment of the present disclosure includes primarily dispersing the filler 120 in a polymerizable composition for forming a light-transmitting matrix 110 to prepare a first mix solution, and casting the first mixture solution to produce a cast film.

According to one embodiment of the present disclosure, a polyimide-based resin solution may be used as the polymerizable composition for forming the light-transmitting matrix 110.

More specifically, the method of manufacturing the optical film 100 according to an embodiment of the present disclosure includes preparing a polyimide-based resin powder, dissolving the polyimide-based resin powder in a first solvent to prepare a polyimide-based resin solution, dispersing the filler 120 in a second solvent to prepare a filler dispersion, and mixing the dispersion with the polyimide-based resin solution to prepare a first mix solution.

DMAc (N,N-dimethylacetamide) may be used as the first solvent. DMAc (N,N-dimethylacetamide) or methyl ethyl ketone (MEK) may be used as the second solvent, but one embodiment of the present disclosure is not limited thereto, and other known solvents as the first solvent and the second solvent may be used.

The filler 120 having a fiber shape, for example, the fiber-shape filler 120 having a high aspect ratio, has a length greater than a diameter thereof and may easily cause aggregation or agglomeration within the light-transmitting matrix. Therefore, the filler 120 requires excellent dispersibility in the first mix solution.

According to one embodiment of the present disclosure, to improve the dispersibility of the filler 120, for example, p-toluene sulfonic acid (PTSA) may be used as an additive. However, the embodiment of the present disclosure is not limited thereto and other known additives may be used to improve the dispersibility of the filler 120.

According to one embodiment of the present disclosure, to improve the dispersibility of the filler 120, for example, the pH of the first mix solution may be adjusted. For example, the pH of the first mix solution may be adjusted to the range of 5 to 7. Accordingly, aggregation or agglomeration of the filler 120 may be prevented.

Next, the first mix solution is cast, dried and heat-treated to form an optical film 100. According to one embodiment of the present disclosure, the film formed by casting the first mix solution may be referred to as a "cast film" and the film produced by drying and heat-treating the cast film may be referred to as an "optical film 100". The cast film can be referred to as an "uncured film".

In order to improve the orientation of the filler 120, casting may be performed by bar coating.

According to one embodiment of the present disclosure, the orientation direction and degree of orientation of the filler 120 can be controlled by adjusting the pressure applied to the cast film formed by casting.

In addition, convection may be prevented during drying and heat treatment of the cast film formed by casting, so that the filler 120 may be oriented in a certain direction.

Specifically, when convection is generated inside the cast film that is dried using heat, the orientation of the filler 120 may decrease. Thus, the cast film may be allowed to be dried slowly to prevent convection. For example, drying of the cast film may be performed while raising the temperature from 80°C to 120°C at a rate of 1°C/1 minute. When drying is performed over a certain level, the orientation of the filler 120 may be fixed.

Hereinafter, the present disclosure will be described in more detail with reference to preparation examples and examples. However, the following preparation examples and examples should not be construed as limiting the scope of the present disclosure.

<Preparation Example: Preparation of solid of polymer-imide-based polymerizable composition>

320.23 g of bis(trifluoromethyl) benzidine (TFDB) was dissolved in dimethylacetamide (DMAc) in a 4-neck double jacketed reactor. Then, 79.44 g of biphenyl tetracarboxylic dianhydride (BPDA) was added thereto and stirred for 2 hours while maintaining the temperature of the reaction tank at 25°C to allow a reaction to occur. After the reaction was completed, 53.31 g of 2,2-bis(3,4-dicarboxyphenyl)hexafluoropropane dianhydride (6FDA) was added and stirred for 1 hour while maintaining the temperature of the reaction tank at 25°C to allow a reaction to occur.

Then, the temperature of the reaction tank was lowered to 7°C or lower, and then 118.77g of terephthaloyl chloride (TPC) and propylene oxide (PO) were added thereto. The temperature of the reaction tank was maintained at 7°C and stirred for 1 hour, the temperature was elevated to room temperature, and the resulting product was allowed to stand for 24 hours.

After the polymerization reaction was completed, 67.87 g of pyridine and 87.62 g of acetic anhydride were added to the obtained polymer solution, the temperature was raised to 80°C, and the mixture was stirred for 1 hour. The result was cooled again to room temperature, and 20 L of methanol was added to the obtained polymerizable composition solution to precipitate the solid. The precipitated solid was filtered and pulverized, washed again with 2 L of methanol, and then dried in vacuum at 100°C for 6 hours to obtain a polyimide-based polymerizable composition as a solid powder. The solid of the polyimide-based polymerizable composition thus prepared was a solid of polyamide-imide polymerizable composition. The yield was 80% or more.

<Example 1>

A 4-neck double-jacketed reaction tank under a nitrogen atmosphere was connected to a circulator to maintain the temperature of the reaction tank at 5°C, and then 5 parts by weight of the filler 120 was added with respect to 100 parts

by weight of the total weight of the polyimide resin powder and 525.17 g of DMAc (first solvent) in the reaction tank, followed by stirring for a predetermined period of time. Then, 85.97 g of the solid powder of the polyimide-based polymerizable composition prepared in Preparation Example was added thereto and stirred until it was dissolved to prepare a polyimide-based resin solution. Here, the filler 120 was a fiber-shape of alumina hydrate including the structure of Formula 1.

The pH measured immediately after preparing the polyimide resin solution was 8 or higher. In order to improve the arrangement characteristics of the filler 120, a weak acid such as acetic acid was added to the polyimide resin solution and the pH of the polyimide resin solution was adjusted to be within the range of 5 to 7. The polyimide-based resin solution thus prepared was a polyimide-based resin solution in which the fibrous filler 120 was dispersed.

The obtained polyimide-based resin solution was cast. A casting substrate was used for casting. At this time, there is no particular limitation on the type of the casting substrate. The casting substrate may be a glass substrate, a stainless steel (SUS) substrate, a Teflon substrate, or the like. According to one embodiment of the present disclosure, a glass substrate was used as the casting substrate.

Specifically, the obtained polyimide-based resin solution was applied to a glass substrate and cast. In order to improve the orientation of the filler 120, the first mix solution was applied to the glass substrate (casting substrate) and cast while applying a force of 30 N in a direction perpendicular to the glass substrate. As a result, a cast film was produced.

Specifically, the cast film was produced by slowly drying in a hot air oven at 80°C up to 120°C at a rate of 1°C/min for about 40 minutes to maintain the orientation of the filler 120. Then, the produced film was peeled off of the glass substrate and fixed to a frame with pins.

The frame to which the optical film was fixed was slowly heated in a vacuum oven from 100°C to 280°C for 2 hours, cooled slowly and separated from the frame to obtain an optical film. The optical film was heated again at 250°C for 5 minutes.

As a result, an optical film 100 having a thickness of 50 μm and including a light-transmitting matrix 110 and an alumina-based filler 120 dispersed in the light-transmitting matrix 110 was completed.

<Examples 2 to 8>

The optical films 100 were produced under the conditions of Table 1 in the same manner as in Example 1 and were respectively referred to as "Examples 2 to 8".

<Comparative Examples 1 to 3>

The optical films 100 were produced under the conditions of Table 1 in the same manner as in Example 1 except for addition of the filler, and were respectively referred to as "Comparative Examples 1 to 3".

[Table 1]

| Item | Diamine monomer | Dianhydride compound | | | Dicarbonyl compound | Type of filler | Content of filler |
|---|---|---|---|---|---|---|---|
| | TFDB | BPDA | CBDA | 6FDA | TPC | | |
| Example 1 | 100 | 27 | - | 12 | 61 | Alumina hydrate (Formula 1) | 5 |
| Example 2 | 100 | 27 | - | 12 | 61 | Alumina hydrate (Formula 1) | 10 |
| Example 3 | 100 | - | 17 | 17 | 66 | Alumina hydrate (Formula 1) | 7 |
| Example 4 | 100 | - | 17 | 17 | 66 | Alumina hydrate (Formula 1) | 10 |
| Example 5 | 100 | - | 26.25 | 12.5 | 61.25 | Alumina hydrate (Formula 1) | 3 |
| Example 6 | 100 | - | 26.25 | 12.5 | 61.25 | Alumina hydrate (Formula 1) | 5 |
| Example 7 | 100 | 27 | - | 12 | 61 | Alumina hydrate (Formula 2) | 5 |
| Example 8 | 100 | 27 | - | 12 | 61 | Alumina hydrate (Formula 3) | 5 |

(continued)

| Item | Diamine monomer | Dianhydride compound | | | Dicarbonyl compound | Type of filler | Content of filler |
|---|---|---|---|---|---|---|---|
| | TFDB | BPDA | CBDA | 6FDA | TPC | | |
| Comparati ve Example 1 | 100 | 27 | - | 12 | 61 | None added | - |
| Comparati ve Example 2 | 100 | - | 17 | 17 | 66 | None added | - |
| Comparati ve Example 3 | 100 | - | 26.25 | 12.5 | 61.25 | None added | |

Alumina hydrate (Formulas 1, 2, and 3) fillers: 4 nm in diameter and 1,500 nm in length.

<Measurement method>

The following measurements were performed on the optical films manufactured according to Examples 1 to 8 and Comparative Examples 1 to 3. In addition, the strain-stress curves of Examples 1 to 6 and Comparative Examples 1 to 3 are shown in FIGS. 7 to 12.

(1) Measurement of Strain-Stress Curve

The strain-stress curves of the optical films manufactured according to Examples 1 to 8 and Comparative Examples 1 to 3 were measured using a dynamic mechanical analysis (DMA) model DMA850 from TA Instruments.

- an RH Chamber (constant temperature and humidity chamber) was connected to control the measurement environments.
- Measurement specimen: length (L) x width (W) x thickness (T) = 5 mm x 2 mm x 0.05 mm
- Treatment under room temperature and humidity conditions: conditions where the optical film specimens are allowed to stand at a temperature of 25°C±3°C and humidity of 30%±5% for 1 hour
- Measurement under high-temperature and high-humidity conditions: conditions where the optical film specimens are allowed to stand at a temperature of 60°C±3°C and humidity of 90%±5% for 1 hour
- The specimen of the optical film manufactured according to each of Examples 1 to 8 and Comparative Examples 1 to 3 was mounted on a film tension clamp and measured using strain sweep method among oscillation tests.

(2) Measurement of yield point

The point where the stress pattern changes rapidly in the strain-stress curve of the optical film measured in (1) above was defined as a yield point. Specifically, the point at which stress begins to decrease or remain constant despite an increase in strain was set as the yield point. The unit of yield point is %.

- First yield point: Yield point on the strain-stress curve after treatment under room temperature and humidity conditions
- Second yield point: yield point in the strain-stress curve after treatment under high temperature and high humidity conditions.

(3) Measurement of first driving toughness and second driving toughness

The area of the strain-stress curve was calculated three times based on the strain of 1.6% in the strain-stress curve measured in (1) above, the average of the three measured areas was multiplied by the length of the specimen and the result was defined as a driving toughness. The unit of driving toughness is MPa·mm.
The first driving toughness is determined by measuring the area of the strain-stress curve based on the strain of 1.6% in the strain-stress curve after treatment under room temperature and high humidity conditions and the second driving toughness is determined by measuring the area of the strain-stress curve based on the strain of 1.6% in the strain-stress curve after treatment under high temperature and high humidity conditions.

(4) Calculation of driving toughness change index

The degree of driving toughness change according to temperature and humidity changes in the optical films manufactured according to Examples 1 to 8 and Comparative Examples 1 to 3 was was defined as the driving toughness change index and was calculated in accordance with Equation 1 below. The unit of the driving toughness change index is %.

[Equation 1]

$$\text{Driving toughness change index(\%)} = \frac{\text{First driving toughness} - \text{Second driving toughness}}{\text{First driving toughness}} \times 100$$

(5) Measurement of first driving elastic limit and second driving elastic limit

The area of the strain-stress curve at a strain of 1.6% in the strain-stress curve measured in (1) above was defined as the driving toughness and a ratio of the driving toughness to the driving strain rate was defined as the driving elastic limit. The first and second driving strain rates are set as 1.6% which corresponds to the strain of the outermost of the film when the radius of curvature (R) of a 50 μm thick film is 1.5R.

The measurement was performed three times and the average of the three measured values was determined as the driving elasticity limit. The unit of the driving elastic limit is MPa·mm.

The first driving elastic limit and the second driving elastic limit were calculated in accordance with Equations 2 and 3 below:

First driving elastic limit = first driving toughness /first driving strain rate [Equation 2]

The first driving elasticity limit is measured after the optical film specimen is treated under room temperature and humidity conditions.

The second driving elastic limit is calculated in accordance with Equation 3 below.

Second driving elastic limit = second driving toughness/second driving strain rate [Equation 3]

The second driving elasticity limit is measured after the optical film specimen is treated under high temperature and humidity conditions.

(6) Measurement of modulus

The modulus of each of the optical films manufactured according to Examples 1 to 8 and Comparative Examples 1 to 3 was measured in accordance with ASTM D885 using an Instron universal tensile tester (MODEL 5967).

- Load Cell 30 kN, Grip 250 N.
- Specimen size 10 mm X 100 mm, tensile speed 25 mm/min
- Since orientation occurs in a coating direction, the coating direction is referred to as "MD" and the direction perpendicular to the coating direction is referred to as "TD".
- Modulus unit: GPa

The measurement results of physical properties are shown in Table 2 below.

[Table 2]

| Item | First yield point | Second yield point | First driving toughness | Second driving toughness | Driving toughness variation index | First driving elastic limit | Second driving elastic limit | Modulus (GPa) |
|---|---|---|---|---|---|---|---|---|
| Example 1 | 2.52 | 2.95 | 255 | 242 | 5.3 | 160 | 151 | 8.0 |
| Example 2 | 1.86 | 2.69 | 333 | 319 | 4.1 | 208 | 199 | 9.3 |
| Example 3 | 1.74 | 2.11 | 418 | 376 | 10.0 | 261 | 235 | 8.4 |
| Example 4 | 1.31 | 1.71 | 459 | 424 | 7.7 | 287 | 265 | 9.3 |
| Example 5 | 1.61 | 1.96 | 371 | 332 | 10.4 | 232 | 208 | 7.5 |
| Example 6 | 1.09 | 1.36 | 451 | 418 | 7.2 | 282 | 261 | 8.4 |
| Example 7 | 2.41 | 2.52 | 232 | 244 | 5.4 | 145 | 153 | 7.8 |
| Example 8 | 2.74 | 2.69 | 233 | 239 | 2.7 | 145 | 149 | 10.0 |
| Comparative Example 1 | 3.14 | 3.94 | 239 | 93.5 | 60.9 | 150 | 58.4 | 5.9 |
| Comparative Example 2 | 2.45 | 2.24 | 370 | 294 | 20.5 | 232 | 184 | 6.0 |
| Comparative Example 3 | 1.80 | 2.41 | 330 | 284 | 14.1 | 206 | 177 | 6.5 |

As can be seen from the results of measurement in Table 2, the optical film 100 according to an embodiment of the present disclosure has excellent driving toughness, excellent driving toughness change index, excellent driving elastic limit, and excellent driving elastic limit index, and thus exhibits excellent mechanical properties.

[Explanation of reference numerals]

| | | | |
|---|---|---|---|
| 100: | Optical film | 110: | Light-transmitting matrix |
| 120: | Filler | 130: | Coating layer |
| 140: | Primer layer | 200, 300: | Cover window substrate |
| 400, 600: | Display device | 501: | Display panel |

## Claims

**1.** An optical film, comprising:

a light-transmitting matrix; and
a filler dispersed in the light-transmitting matrix,
wherein the filler has a fiber shape and a driving toughness change index of 10.5% or less,
wherein the driving toughness change index is calculated in accordance with Equation 1 below:

[Equation 1]

$$\text{Driving toughness change index}(\%) = \frac{\text{First driving toughness} - \text{Second driving toughness}}{\text{First driving toughness}} \times 100$$

wherein the first driving toughness is driving toughness measured after treatment under room temperature and humidity conditions,
the treatment under room temperature and humidity conditions is performed by allowing the optical film to stand at a temperature of 25°C ± 3°C and humidity of 30% ± 5% for 1 hour,
the second driving toughness is driving toughness measured after treatment under high temperature and humidity conditions,
the treatment under high temperature and humidity conditions is performed by allowing the optical film to stand at a temperature of 60°C ± 3°C and humidity of 90% ± 5% for 1 hour, and
the driving toughness is defined by measuring a ratio of strain to stress of the optical film using a dynamic mechanical analyzer (DMA), obtaining a strain-stress curve using the strain of the optical film on an x-axis and the stress of the optical film on a y-axis, and calculating a product of an area at a strain of 1.6% or less in the strain-stress curve, by a length of a specimen.

**2.** The optical film according to claim 1, wherein the optical film has a first driving toughness of 240 MPa·mm or more.

**3.** The optical film according to claim 1, wherein the optical film has a second driving toughness of 217 MPa ·mm or more.

**4.** The optical film according to claim 2, wherein the optical film has a first driving elastic limit of 155 MPa·mm or more,

wherein the first driving elastic limit is calculated in accordance with Equation 2 below:

First driving elastic limit = first driving toughness /first driving strain rate --> [Equation 2]

wherein the first driving strain rate is 1.6%.

**5.** The optical film according to claim 3, wherein the optical film has a second driving elastic limit of 140 MPa·mm or more,

wherein the second driving elastic limit is calculated in accordance with Equation 3 below:

Second driving elastic limit = second driving toughness/second driving strain rate [Equation 3]

wherein the second driving strain rate is 1.6%.

**6.** The optical film according to claim 1, wherein the filler comprises at least one of glass fiber, aluminum-based fiber, or fluoride fiber.

**7.** The optical film according to claim 1, wherein the filler comprises at least one of aluminum oxide hydroxide, $SiO_2$, $Al_2O_3$, polytetrafluoroethylene (PTFE), or polyvinylidene fluoride (PVDF).

**8.** The optical film according to claim 1, wherein the light-transmitting matrix is produced from a polymerizable composition comprising:

a diamine monomer; and
at least one of a dianhydride compound or a dicarbonyl compound.

**9.** The optical film according to claim 8, wherein the light-transmitting matrix comprises at least one of an imide repeating unit or an amide repeating unit.

**10.** The optical film according to claim 8, wherein the diamine monomer comprises at least one of 2,2'-bis(trifluoromethyl) benzidine (TFDB), 4,4'-oxydianiline (ODA), p-phenylene diamine (pPDA), m-phenylene diamine (mPDA), p-methylene diamine (pMDA), m-methylene diamine (mMDA), 1,3-bis(3-aminophenoxy)benzene (133APB), 1,3-bis(4-aminophenoxy)benzene (134APB), 2,2'-bis[4(4-aminophenoxy)phenyl]hexafluoropropane (4BDAF), 2,2'-bis(3-aminophenyl)hexafluoropropane (33-6F), 2,2'-bis(4-aminophenyl)hexafluoropropane (44-6F), bis(4-aminophenyl)sulfone (4DDS), bis(aminophenyl)sulfone (3DDS), 1,3-cyclohexanediamine (13CHD), 1,4-cyclohexanediamine (14CHD), 2,2-bis[4-(4-aminophenoxy)-phenyl]propane (6HMDA), 2,2-bis(3-amino-4-hydroxy-phenyl)-hexafluoropropane (DBOH), or 4,4'-bis(3-aminophenoxy)diphenyl sulfone (DBSDA).

**11.** The optical film according to claim 8, wherein the dianhydride compound comprises at least one of 3,3,4,4-biphenyltetracarboxylic dianhydride (BPDA), 2,2-bis(3,4-dicarboxyphenyl)hexafluoropropane dianhydride (6FDA), 4-(2,5-dioxotetrahydrofuran-3-yl)-1,2,3,4-tetrahydronaphthalene-1,2-dicarboxylic anhydride (TDA), 1,2,4,5-benzene tetracarboxylic dianhydride (pyromellitic dianhydride, PMDA), 3,3,4,4-benzophenone tetracarboxylic dianhydride (BTDA), 4,4-oxydiphthalic dianhydride (ODPA), bis(3,4-dicarboxyphenyl)dimethyl-silane dianhydride (SiDA), 4,4-bis(3,4-dicarboxyphenoxy)diphenyl sulfide dianhydride (BDSDA), sulfonyl diphthalic anhydride (SO2DPA), cyclobutane-1,2,3,4-tetracarboxylic dianhydride (CBDA), or 4,4'-(4,4'-isopropylidenediphenoxy)bis(phthalic anhydride) (6HBDA).

**12.** The optical film according to claim 8, wherein the dicarbonyl compound comprises at least one of terephthaloyl chloride (TPC), phthaloyl chloride, isophthaloyl chloride (IPC), 4,4'-biphenyldicarbonyl chloride (DPDOC), 4,4'-oxybis (benzoyl chloride) (OBBOC), naphthalene-2,3-dicarbonyl dichloride, or 1,4-cyclohexanedicabonyldichloride (CHDOC).

**13.** The optical film according to claim 8, wherein a molar ratio of the dianhydride compound to the dicarbonyl compound falls within a range of 5:95 to 40:60.

**14.** A cover window substrate, comprising:
the optical film according to any one of claims 1 to 13.

**15.** A cover window substrate, comprising:

a light-transmitting sheet; and
a coating layer disposed on the light-transmitting sheet,
wherein the light-transmitting sheet comprises the optical film according to any one of claims 1 to 13.

**16.** The cover window substrate according to claim 15, further comprising:
a primer layer between the light-transmitting sheet and the coating layer.

**17.** A display device, comprising:

a display panel; and
the optical film according to any one of claims 1 to 13 disposed on the display panel.

FIG. 1

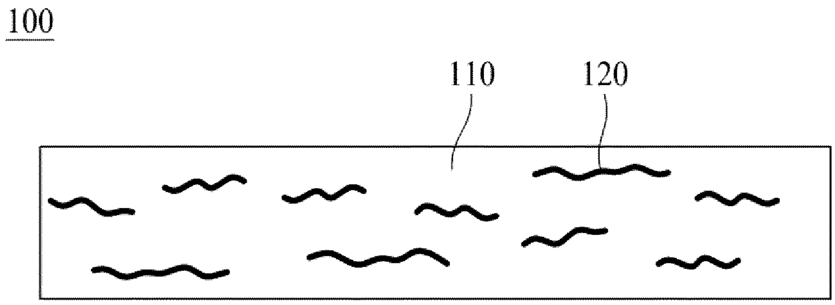


FIG. 2

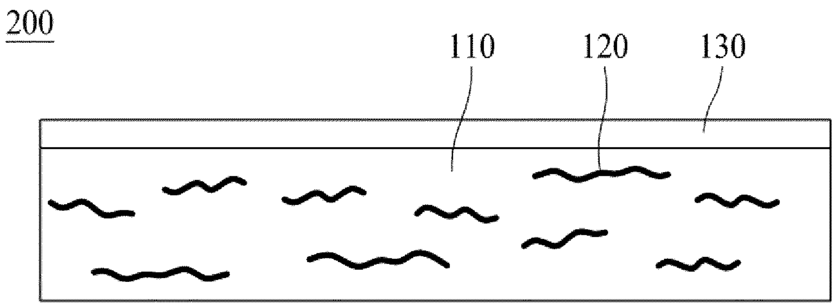


FIG. 3

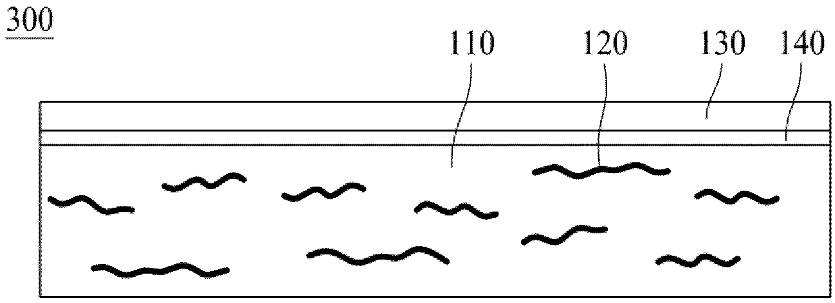

FIG. 4

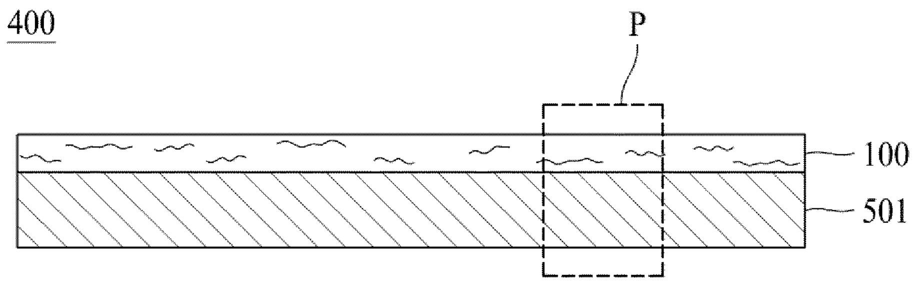
400
P
100
501

FIG. 5

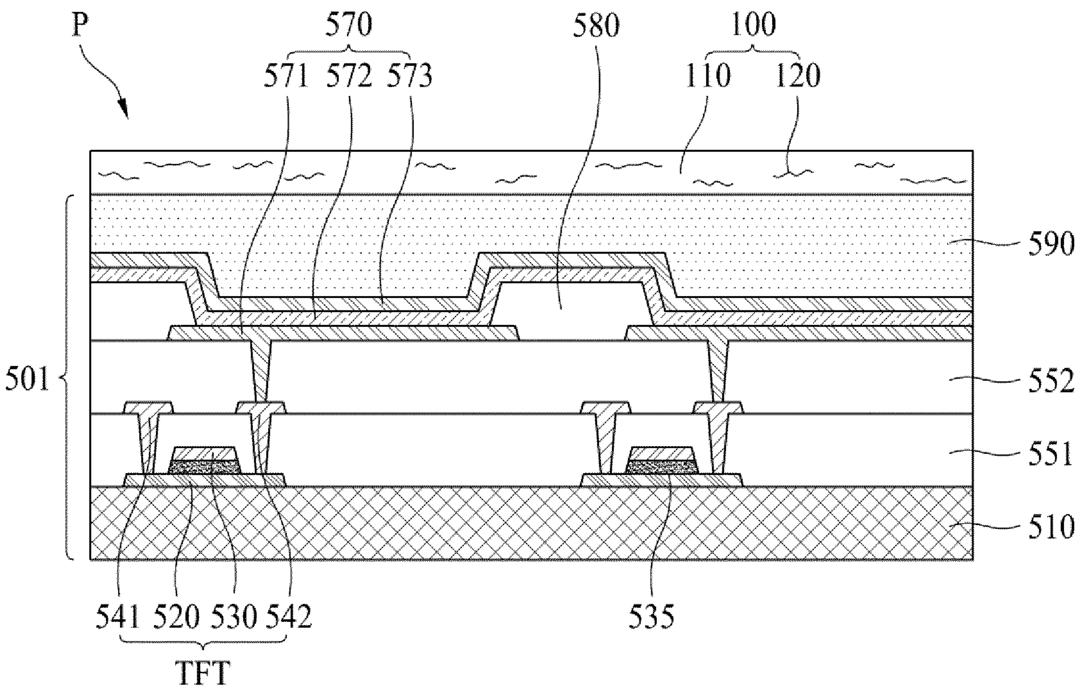
P
570
571 572 573
580
100
110 120
590
501
552
551
510
541 520 530 542
535
TFT

FIG. 6

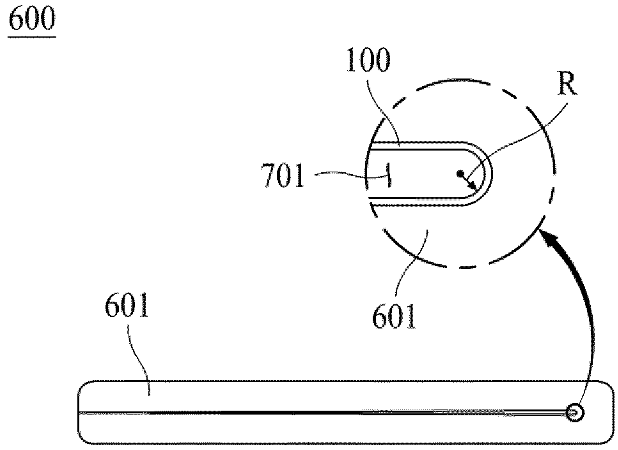

FIG. 7

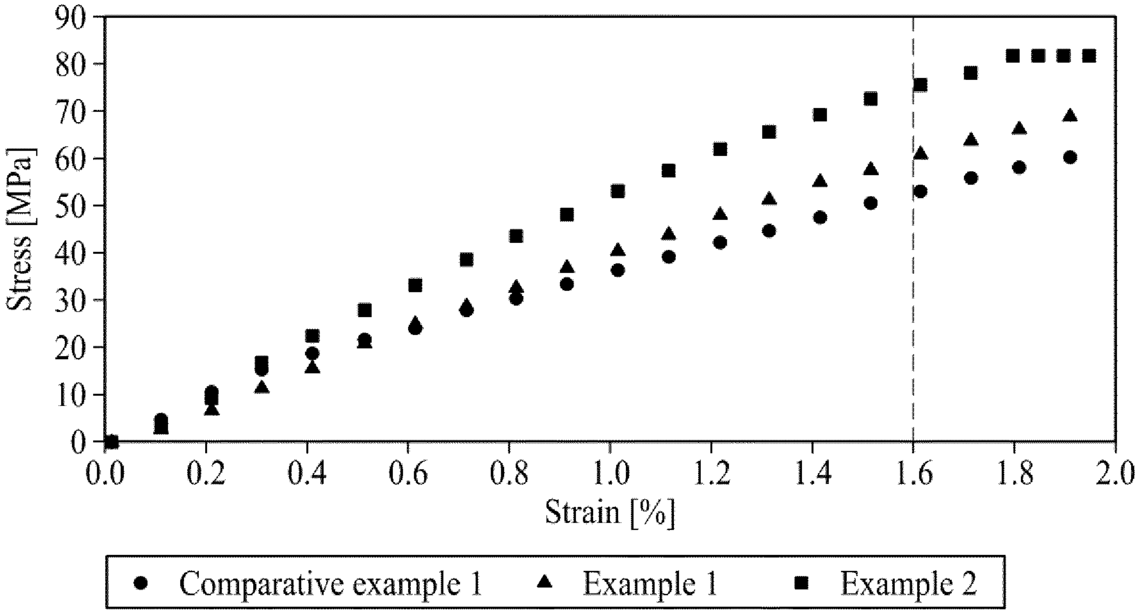
90
80
70
60
50
40
30
20
10
0
Stress [MPa]
0.0
0.2
0.4
0.6
0.8
1.0
1.2
1.4
1.6
1.8
2.0
Strain [%]
Comparative example 1
Example 1
Example 2

FIG. 8

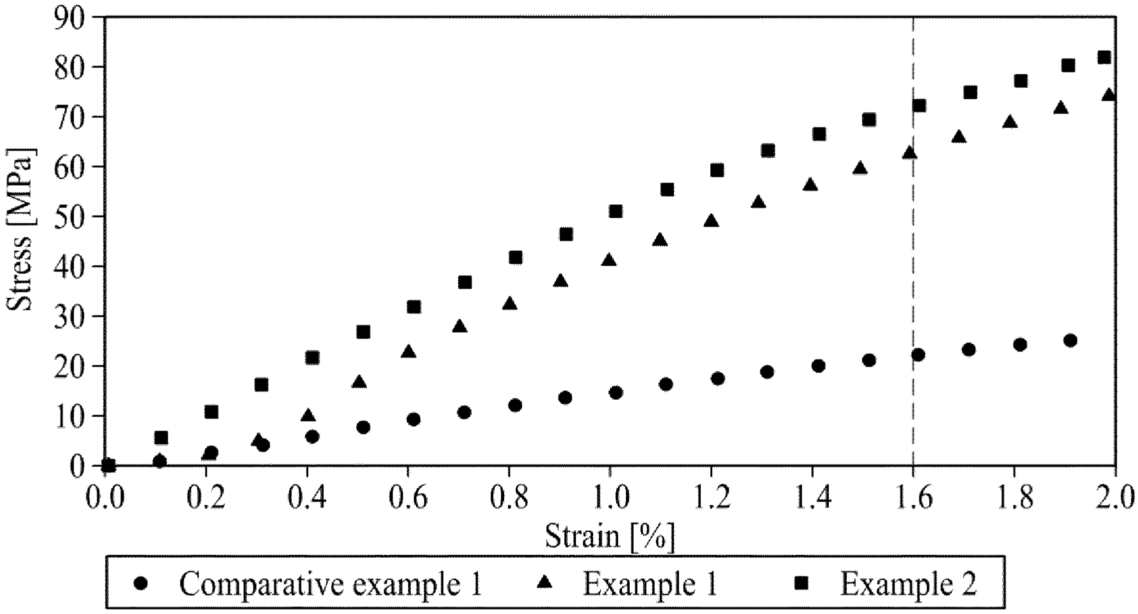
90
80
70
60
50
40
30
20
10
0
Stress [MPa]
0.0
0.2
0.4
0.6
0.8
1.0
1.2
1.4
1.6
1.8
2.0
Strain [%]
Comparative example 1
Example 1
Example 2

FIG. 9

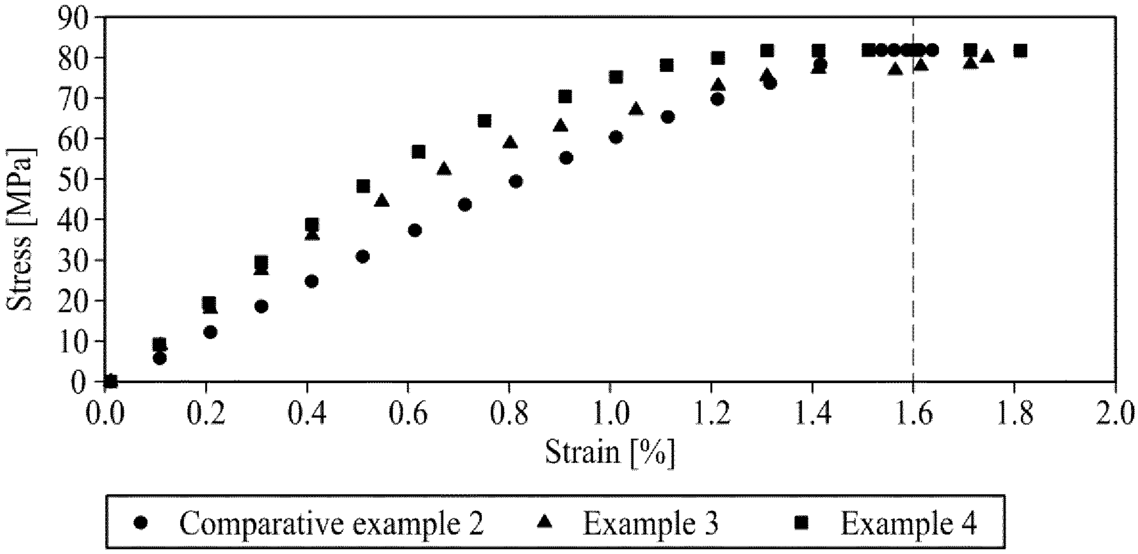
90
80
70
60
50
40
30
20
10
0
Stress [MPa]
0.0
0.2
0.4
0.6
0.8
1.0
1.2
1.4
1.6
1.8
2.0
Strain [%]
Comparative example 2
Example 3
Example 4

FIG. 10

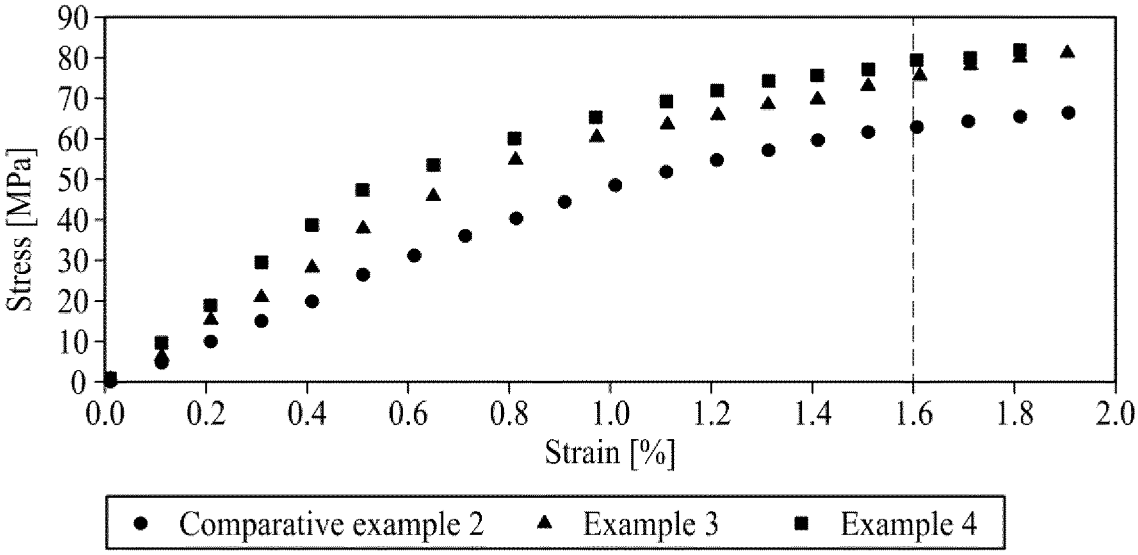
90
80
70
60
50
40
30
20
10
0
Stress [MPa]
0.0
0.2
0.4
0.6
0.8
1.0
1.2
1.4
1.6
1.8
2.0
Strain [%]
Comparative example 2
Example 3
Example 4

FIG. 11

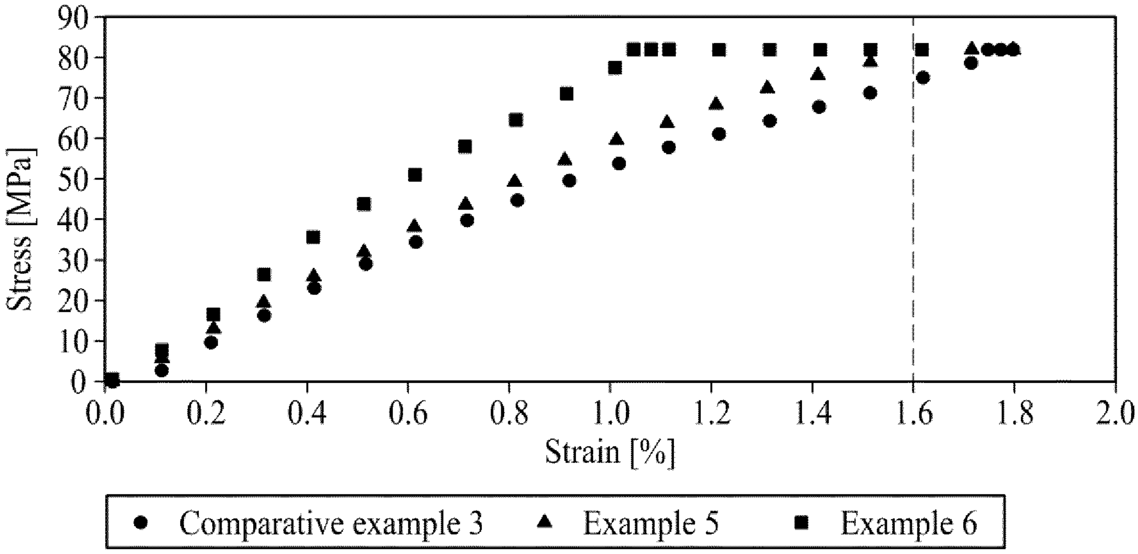
Stress [MPa]
90
80
70
60
50
40
30
20
10
0
0.0
0.2
0.4
0.6
0.8
1.0
1.2
1.4
1.6
1.8
2.0
Strain [%]
Comparative example 3
Example 5
Example 6

FIG. 12

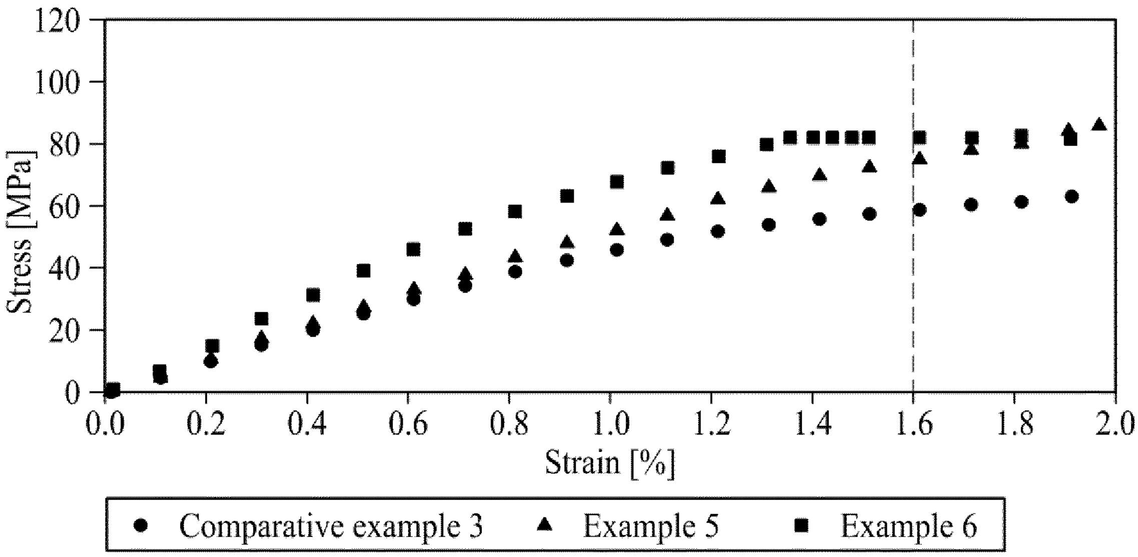
Stress [MPa]
120
100
80
60
40
20
0
0.0
0.2
0.4
0.6
0.8
1.0
1.2
1.4
1.6
1.8
2.0
Strain [%]
Comparative example 3
Example 5
Example 6

## INTERNATIONAL SEARCH REPORT

International application No.
**PCT/KR2023/014665**

**A. CLASSIFICATION OF SUBJECT MATTER**

**G02B 5/20**(2006.01)i; **G02B 5/18**(2006.01)i; **C08K 7/04**(2006.01)i; **H10K 50/85**(2023.01)i; **C08K 3/22**(2006.01)i; **C08K 3/36**(2006.01)i; **C08L 27/18**(2006.01)i; **C08L 79/08**(2006.01)i; **C08G 73/10**(2006.01)i; **C08J 7/043**(2020.01)i

According to International Patent Classification (IPC) or to both national classification and IPC

**B. FIELDS SEARCHED**

Minimum documentation searched (classification system followed by classification symbols)

G02B 5/20(2006.01); B32B 7/02(2006.01); C08J 5/18(2006.01); G02B 1/10(2006.01); G02B 1/14(2015.01); G02B 5/30(2006.01); G09F 9/30(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 광학 필름(optical film), 섬유(fiber), 필러(filler), 응력(stress), 변형률(strain), 습도(humidity), 온도(temperature)

**C. DOCUMENTS CONSIDERED TO BE RELEVANT**

| Category* | Citation of document, with indication, where appropriate, of the relevant passages | Relevant to claim No. |
|---|---|---|
| A | WO 2022-010253 A1 (KOLON INDUSTRIES, INC.) 13 January 2022 (2022-01-13)<br>See paragraph [0213]; claim 8; and figures 1-4. | 1-17 |
| A | KR 10-2009-0064421 A (DAI NIPPON PRINTING CO., LTD.) 18 June 2009 (2009-06-18)<br>See paragraphs [0028] and [0153]; and figure 1. | 1-17 |
| A | KR 10-1801471 B1 (DONGWOO FINE-CHEM CO., LTD.) 24 November 2017 (2017-11-24)<br>See claims 1-3; and figure 1. | 1-17 |
| A | KR 10-2017-0001297 A (DONGWOO FINE-CHEM CO., LTD.) 04 January 2017 (2017-01-04)<br>See claim 9; and figure 1. | 1-17 |
| A | US 2007-0279741 A1 (YOSHIOKA, Masahiro et al.) 06 December 2007 (2007-12-06)<br>See claim 1; and figure 1. | 1-17 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 January 2024** | **04 January 2024** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2022)

**INTERNATIONAL SEARCH REPORT**
**Information on patent family members**

International application No.
**PCT/KR2023/014665**

| Patent document cited in search report | Publication date (day/month/year) | Patent family member(s) | Publication date (day/month/year) |
|---|---|---|---|
| WO 2022-010253 A1 | 13 January 2022 | CN 115836105 A | 21 March 2023 |
| | | JP 2023-533274 A | 02 August 2023 |
| | | KR 10-2022-0007532 A | 18 January 2022 |
| | | KR 10-2022-0007533 A | 18 January 2022 |
| | | TW 202208524 A | 01 March 2022 |
| | | TW I779712 B | 01 October 2022 |
| | | US 2023-0312881 A1 | 05 October 2023 |
| KR 10-2009-0064421 A | 18 June 2009 | CN 101523240 A | 02 September 2009 |
| | | TW 200831941 A | 01 August 2008 |
| | | TW I402534 B | 21 July 2013 |
| | | US 2010-0028682 A1 | 04 February 2010 |
| | | WO 2008-038714 A1 | 03 April 2008 |
| KR 10-1801471 B1 | 24 November 2017 | CN 107544100 A | 05 January 2018 |
| | | CN 107544100 B | 27 July 2021 |
| | | JP 2018-020552 A | 08 February 2018 |
| | | JP 6947547 B2 | 13 October 2021 |
| | | TW 201831609 A | 01 September 2018 |
| | | TW I717529 B | 01 February 2021 |
| | | US 2017-0369712 A1 | 28 December 2017 |
| | | US 2020-0377735 A1 | 03 December 2020 |
| KR 10-2017-0001297 A | 04 January 2017 | CN 106273944 A | 04 January 2017 |
| | | JP 2017-013492 A | 19 January 2017 |
| | | JP 6896378 B2 | 30 June 2021 |
| | | KR 10-2031556 B1 | 14 October 2019 |
| | | TW 201726387 A | 01 August 2017 |
| US 2007-0279741 A1 | 06 December 2007 | CN 1934469 A | 21 March 2007 |
| | | JP 2005-309401 A | 04 November 2005 |
| | | JP 4583982 B2 | 17 November 2010 |
| | | KR 10-0849873 B1 | 01 August 2008 |
| | | KR 10-2007-0015172 A | 01 February 2007 |
| | | TW 200609543 A | 16 March 2006 |
| | | WO 2005-091023 A1 | 29 September 2005 |

Form PCT/ISA/210 (patent family annex) (July 2022)